(19) Europäisches Patentamt
European Patent Office
Office européen des brevets

(11) **EP 3 310 597 B1**

(12) **FASCICULE DE BREVET EUROPEEN**

(45) Date de publication et mention de la délivrance du brevet:
**08.09.2021 Bulletin 2021/36**

(21) Numéro de dépôt: **16730726.3**

(22) Date de dépôt: **03.06.2016**

(51) Int Cl.:
**B60H 3/02** (2006.01)    **F24F 6/00** (2006.01)
**G01N 27/06** (2006.01)    **G01R 27/22** (2006.01)

(86) Numéro de dépôt international:
**PCT/EP2016/062717**

(87) Numéro de publication internationale:
**WO 2016/206954 (29.12.2016 Gazette 2016/52)**

(54) **DISPOSITIF DE NEBULISATION POUR VEHICULE AUTOMOBILE**

VERNEBELUNGSVORRICHTUNG FÜR EIN KRAFTFAHRZEUG

NEBULIZATION DEVICE FOR MOTOR VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.06.2015 FR 1555728**

(43) Date de publication de la demande:
**25.04.2018 Bulletin 2018/17**

(73) Titulaire: **Valeo Systemes Thermiques**
**78320 Le Mesnil Saint Denis (FR)**

(72) Inventeur: **FOURNIER, Jonathan**
**78322 Le Mesnil-Saint-Denis Cedex (FR)**

(74) Mandataire: **Tran, Chi-Hai et al**
**Valeo Systèmes Thermiques**
**BG THS - Service Propriété Industrielle THS**
**ZA L' Agiot, 8 rue Louis Lormand**
**CS 80517 La Verrière**
**78322 Le Mesnil Saint Denis Cedex (FR)**

(56) Documents cités:
**WO-A1-2009/081253    FR-A1- 2 788 705**
**JP-A- H03 271 019    US-A- 4 257 989**
**US-A- 5 699 983**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Printed by Jouve, 75001 PARIS (FR)

## Description

DOMAINE TECHNIQUE DE L'INVENTION

La présente invention concerne un dispositif de nébulisation pour véhicule automobile.

Elle trouve une application particulière, mais non limitative dans les véhicules automobiles.

ARRIÈRE-PLAN TECHNOLOGIQUE DE L'INVENTION

De plus en plus de véhicules automobiles comprennent un dispositif de nébulisation qui permet d'envoyer des fines gouttelettes de liquide dans l'habitacle du véhicule automobile pour le rafraichir.

Un tel dispositif de nébulisation offre ainsi une fonctionnalité de confort qui permet notamment d'éviter que les yeux du conducteur et des passagers du véhicule automobile ne se dessèchent. Un dispositif de nébulisation connu de l'homme du métier comprend un nébuliseur couplé à une unité d'alimentation en liquide du nébuliseur qui contient un liquide de nébulisation. A partir du liquide de nébulisation, le nébuliseur génère une brume composée de fines gouttelettes.

Un tel dispositif de nébulisation est connu du document FR 2 788 705, et comprend un nébuliseur adapté pour effectuer une nébulisation d'un liquide de nébulisation, une unité de dégradation adaptée pour dégrader des composés organiques dans ledit liquide de nébulisation, et au moins une cellule de conductivité adaptée pour mesurer la conductivité du liquide de nébulisation.

Un inconvénient de cet état de la technique est que si la qualité du liquide de nébulisation se dégrade, notamment en présence d'une grande quantité de composés organiques, on rafraîchit l'habitacle du véhicule automobile et donc les occupants dudit véhicule automobile avec un liquide de nébulisation de mauvaise qualité.

Dans ce contexte, la présente invention vise à résoudre au moins l'inconvénient précédemment mentionné.

DESCRIPTION GENERALE DE L'INVENTION

A cette fin, l'invention propose un dispositif de nébulisation pour véhicule automobile, selon la revendication 1, dans lequel une cellule de conductivité est couplée à une unité de calcul adaptée pour déterminer le carbone organique total dans le liquide de nébulisation.

Ainsi, comme on va le voir en détail ci-après, en dégradant les composés organiques, l'unité de dégradation modifie la conductivité du liquide de nébulisation. Par ailleurs, en mesurant la conductivité du liquide de nébulisation, on peut en déduire le carbone organique total dans ledit liquide de nébulisation et ainsi vérifier la qualité dudit liquide de nébulisation. En fonction de la valeur du carbone organique total, on autorise ou non la nébulisation.

Selon des modes de réalisation non limitatifs, le dispositif de nébulisation peut comporter en outre une ou plusieurs caractéristiques supplémentaires parmi les suivantes :

Selon un mode de réalisation non limitatif, l'unité de dégradation est une lampe à ultra-violet.

C'est un moyen simple de dégrader des composés organiques.

Selon un mode de réalisation non limitatif, l'unité de dégradation est réglée pour émettre des ondes électromagnétiques d'une longueur d'onde comprise entre 184 nanomètres et 254 nanomètres. Cette plage de valeur est une plage optimum pour dégrader des composés organiques se trouvant dans un liquide de nébulisation, tel que de l'eau potable.

Selon un mode de réalisation non limitatif, ladite au moins une cellule de conductivité est adaptée pour mesurer la conductivité du liquide de nébulisation avant le passage du liquide de nébulisation devant ladite unité de dégradation.

Cela permet d'effectuer une mesure avant que les composés organiques du liquide de nébulisation ne subissent une dégradation par l'unité de dégradation, la première fois que l'unité de dégradation est activée.

Selon un mode de réalisation non limitatif, ledit dispositif de nébulisation comprend en outre une deuxième cellule de conductivité adaptée pour mesurer la conductivité du liquide de nébulisation après le passage du liquide de nébulisation devant ladite unité de dégradation.

Cela permet d'effectuer une mesure après que les composés organiques du liquide de nébulisation ne subissent une dégradation par l'unité de dégradation.

Selon l'invention, au moins une cellule de conductivité est couplée à une unité de calcul adaptée pour déterminer le carbone organique total dans ledit liquide de nébulisation.

Cela permet de déterminer le carbone organique total en fonction de la conductivité.

Selon un mode de réalisation non limitatif, le carbone organique total est déterminé en fonction d'une différence de mesures de conductivité par une cellule de conductivité.

Cela permet de n'utiliser qu'une seule cellule de conductivité.

Selon un mode de réalisation non limitatif, le carbone organique total est déterminé en fonction d'une différence de mesures de conductivité par deux cellules de conductivité.

Cela permet d'avoir une mesure fine du carbone organique total, notamment lorsque le liquide de nébulisation comporte une conductivité élevée.

Selon un mode de réalisation non limitatif, si le liquide de nébulisation comporte un carbone organique total supérieur à un seuil prédéterminé, le nébuliseur est désactivé.

Cela permet d'arrêter d'envoyer des gouttelettes de liquide dans l'habitacle du véhicule automobile si le liquide de nébulisation comporte trop de composés organiques.

Selon un mode de réalisation non limitatif, le dispositif de nébulisation comprend en outre des moyens d'alerte adaptés pour être déclenchés si le liquide de nébulisation comporte un carbone organique total supérieur à un seuil prédéterminé.

Cela permet d'indiquer que le liquide de nébulisation doit être changé dans le cas où la dégradation des composés organiques n'est pas suffisamment efficace.

Selon un mode de réalisation non limitatif, ledit seuil prédéterminé est égal à 2 milligrammes par litre. Cela correspond à la limite au-delà de laquelle le liquide de nébulisation n'est plus de bonne qualité.

Selon un mode de réalisation non limitatif, ledit dispositif de nébulisation comprend en outre :

- une unité d'alimentation en liquide du nébuliseur adaptée pour recevoir un liquide de nébulisation ;
- un réservoir adapté pour recevoir le liquide de nébulisation et relié à un conduit de dégradation ;
- une pompe couplée audit réservoir.

Selon un mode de réalisation non limitatif, ledit dispositif de nébulisation comprend en outre :

- une unité d'alimentation en liquide du nébuliseur reliée à un conduit de dégradation et adaptée pour recevoir un liquide de nébulisation ;
- une pompe couplée à ladite unité d'alimentation en liquide ;

On utilise l'unité d'alimentation en liquide également comme réservoir pour le conduit de dégradation. On supprime ainsi un composant supplémentaire par rapport au mode de réalisation précédent.

Selon un mode de réalisation non limitatif,

- l'unité de dégradation est couplée audit conduit de dégradation ; et
- ladite au moins une cellule de conductivité est située à l'intérieur du conduit de dégradation.

Selon un mode de réalisation non limitatif, le dispositif de nébulisation comprend en outre une électrovanne adaptée pour :

- diriger le liquide de nébulisation nébulisé de l'unité d'alimentation en liquide vers un diffuseur si le carbone organique total est inférieur ou égal à un seuil prédéterminé ; ou
- diriger le liquide de nébulisation de l'unité d'alimentation en liquide vers le conduit de dégradation si le carbone organique total est supérieur au seuil prédéterminé ; et
- arrêter d'alimenter en liquide de nébulisation nébulisé le diffuseur si le carbone organique total est supérieur au seuil prédéterminé.

Selon un mode de réalisation non limitatif, l'unité de dégradation est disposée à l'intérieur ou à l'extérieur du conduit de dégradation. A l'intérieur, le liquide de nébulisation peut circuler autour de l'unité de dégradation. La décomposition des composés organiques sera donc plus efficace.

Selon un mode de réalisation non limitatif, ladite unité d'alimentation en liquide est :

- un réservoir de nébulisation ; ou
- un conduit de nébulisation dans lequel le liquide de nébulisation peut s'écouler.

Selon un mode de réalisation non limitatif, le nébuliseur est situé à l'intérieur ou à l'extérieur de ladite unité d'alimentation en liquide.

Selon un mode de réalisation non limitatif, ledit dispositif de nébulisation comprend en outre au moins un capteur de température relié à au moins une cellule de conductivité et adapté pour fournir une température du liquide de nébulisation.

La conductivité varie en fonction de la température. Le capteur de température permet de mesurer la température réelle du liquide de nébulisation. La mesure de conductivité est corrigée par la suite en fonction d'une température de référence.

BREVE DESCRIPTION DES FIGURES

L'invention et ses différentes applications seront mieux comprises à la lecture de la description qui suit et à l'examen des figures qui l'accompagnent.

- la figure 1 représente un schéma d'un dispositif de nébulisation pour un véhicule automobile, ledit dispositif comprenant une unité de dégradation de composés organiques, un nébuliseur et une cellule de conductivité, selon un premier mode de réalisation non limitatif de l'invention ;
- la figure 2 représente un schéma d'une cellule de conductivité plongée dans une unité d'alimentation en liquide du dispositif de nébulisation selon l'invention et selon un mode de réalisation non limitatif de l'invention ;
- la figure 3 représente un schéma d'un dispositif de nébulisation pour un véhicule automobile, ledit dispositif comprenant une unité de dégradation de composés organiques, un nébuliseur, deux cellules de conductivité, selon un deuxième mode de réalisation non limitatif de l'invention ;
- la figure 4 représente un schéma d'un dispositif de nébulisation pour un véhicule automobile, ledit dispositif comprenant une unité de dégradation de composés organiques, un nébuliseur, deux cellules de conductivité, selon un troisième mode de réalisation non limitatif de l'invention ;
- la figure 5 représente le dispositif de nébulisation de la figure 4 comprenant en outre un capteur de température, selon un mode de réalisation non limitatif de l'invention ; et

- la figure 6 représente un schéma d'un dispositif de nébulisation pour un véhicule automobile, ledit dispositif comprenant une unité de dégradation de composés organiques, un nébuliseur, deux cellules de conductivité, selon un quatrième mode de réalisation non limitatif de l'invention.

DESCRIPTION DE MODES DE REALISATION DE L'INVENTION

Les éléments identiques, par structure ou par fonction, apparaissant sur différentes figures conservent, sauf précision contraire, les mêmes références.

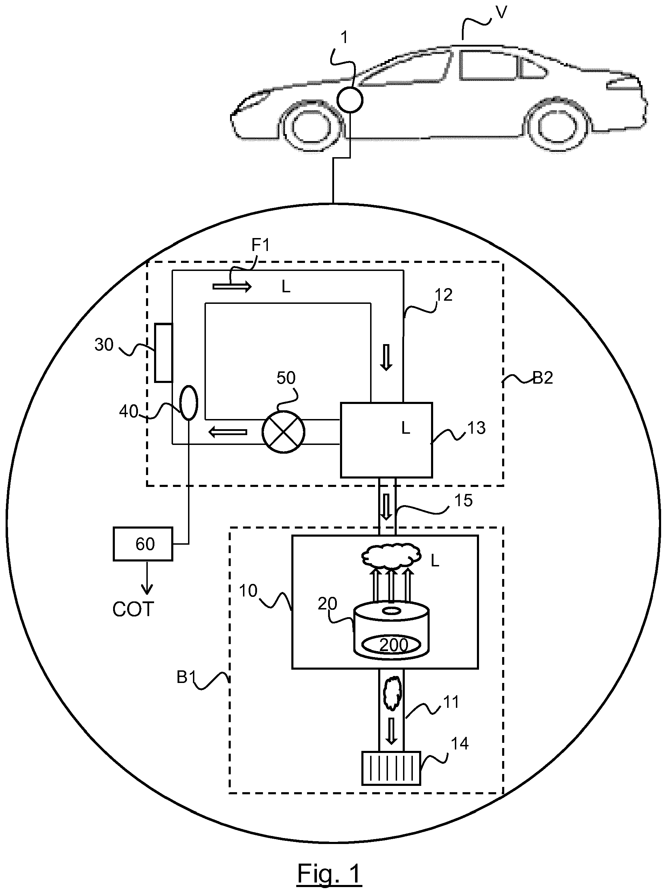

Le dispositif de nébulisation 1 pour véhicule automobile V, est illustré schématiquement sur les figures 1 et 3 à 6.
Par véhicule automobile, on entend tout type de véhicule motorisé.
Dans la description, par liquide de nébulisation L nébulisé, on entend le liquide de nébulisation sous forme de fines gouttelettes.

Tel qu'illustré sur ces figures, le dispositif de nébulisation 1 comprend :

- un nébuliseur 20 adapté pour effectuer une nébulisation d'un liquide de nébulisation L ;
- une unité de dégradation 30 de composés organiques O adaptée pour dégrader des composés organiques O dans ledit liquide de nébulisation L;
- au moins une cellule de conductivité 40 adaptée pour mesurer la conductivité du liquide de nébulisation L.

Dans un mode de réalisation non limitatif, le dispositif de nébulisation 1 comprend en outre une unité d'alimentation en liquide 10 du nébuliseur 20 adaptée pour recevoir un liquide de nébulisation L.

Les différents éléments du dispositif de nébulisation 1 sont décrits plus en détail ci-après.

• Nébuliseur et _unité d'alimentation en liquide

Dans un mode de réalisation non limitatif, le nébuliseur 20 est un nébuliseur qui comprend un oscillateur piézo-électrique 200 et une membrane souple (non illustrée). Le nébuliseur 20 fonctionne à une fréquence d'environ 2MHz dans un exemple non limitatif. Il permet la nébulisation du liquide de nébulisation L : l'oscillateur piézo-électrique 200 fait vibrer la membrane souple pour produire de fines gouttelettes de liquide à partir du liquide de nébulisation. Il est immergé dans le liquide de nébulisation L et est alimenté par un courant électrique. Les fines gouttelettes de liquide produites sont acheminées via au moins un conduit de circulation appelé conduit de nébulisation 11 et diffusées via un diffuseur 14 dans l'habitacle du véhicule automobile V. Dans un exemple non limitatif, le diffuseur 14 comprend une tête de nébulisation (non illustrée) présentant des buses pour délivrer les fines gouttelettes de liquide dans ledit habitacle via dans un exemple non limitatif des volets d'aération. On notera que dans un mode de réalisation non limitatif, la taille des gouttelettes peut varier du micromètre à quelques dizaines de micromètres.

Dans des modes de réalisation non limitatifs, l'unité d'alimentation en liquide 10 est :

- un réservoir de nébulisation ; ou
- un conduit de nébulisation dans lequel le liquide de nébulisation L peut s'écouler.

Dans les exemples non limitatifs illustrés sur les figures, l'unité d'alimentation en liquide 10 est un réservoir de nébulisation.
Dans des modes de réalisation non limitatifs, le nébuliseur 20 est situé à l'intérieur ou à l'extérieur de l'unité d'alimentation en liquide 10. Dans le deuxième cas, lorsque l'unité d'alimentation en liquide 10 est placée à distance du nébuliseur 20, il est prévu de la relier au nébuliseur 20 via un tube dans un exemple non limitatif, qui alimentera ainsi le nébuliseur 20 en liquide de nébulisation L.
Dans les exemples non limitatifs illustrés sur les figures, le nébuliseur 20 est placé dans l'unité d'alimentation en liquide 10.

Dans un mode de réalisation non limitatif, le liquide de nébulisation L est de l'eau potable (dans des exemples non limitatifs de l'eau du robinet, de l'eau de source ou de l'eau minérale). On notera que l'eau potable comporte en général une conductivité $\sigma$ (en siemens par centimètre (S/cm)) comprise entre 200 $\mu$S/cm et 1100 $\mu$S/cm à 25°C.

• Cellule de conductivité

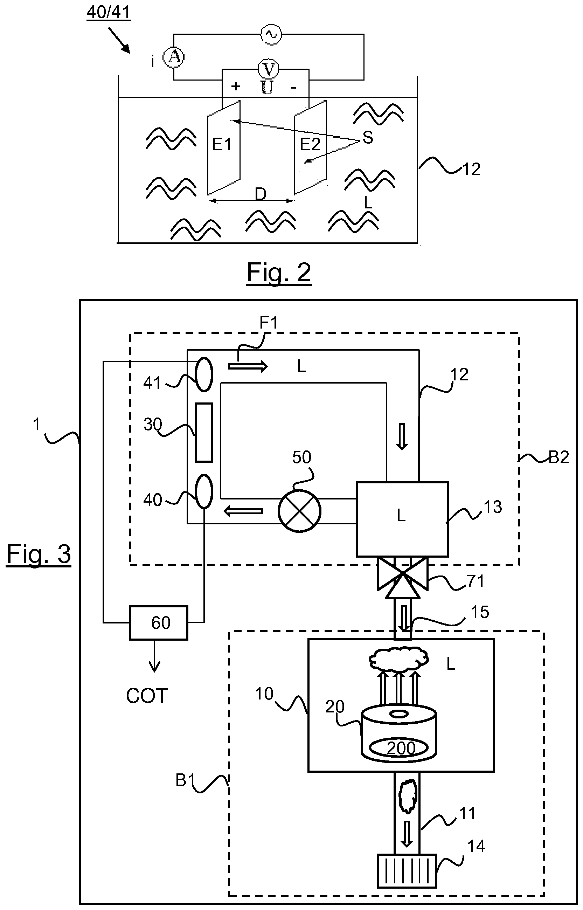

La cellule de conductivité 40 est illustrée plus en détail sur la figure 2. Elle comporte deux électrodes E1 et E2 qui sont des plaques parallèles entre elles et séparées l'une de l'autre par une distance D. Elles ont une surface S.

Dans un exemple non limitatif, les plaques E1 et E2 sont en platine. Dans d'autres exemples non limitatifs, les plaques E1 et E2 sont en acier inoxydable, en titane, en palladium, en iridium, ou en rhodium.
On notera que le matériau utilisé pour les plaques est choisi de sorte qu'il ne se dégrade pas ou très peu lorsque l'unité de dégradation 30 est activée, et ce pour éviter de fausser les mesures de conductivité du liquide de nébulisation.
La cellule de conductivité 40 permet une mesure de l'impédance R1 du liquide de nébulisation L et par conséquent permet de déterminer sa conductivité $\sigma$.
De manière générale, la conductivité $\sigma$ est la capacité d'une solution à faire passer un courant électrique. Dans une solution, les anions et les cations transportent le courant. Les cations migrent en direction de l'électrode négative, et les anions migrent en direction de l'électrode positive. La solution se comporte alors comme un conducteur électrique.

La conductivité $\sigma$ se mesure en appliquant un courant alternatif i aux deux électrodes E1, E2 immergées dans le liquide de nébulisation L.

On détermine la conductivité $\sigma$ du liquide de nébulisation L en mesurant son impédance R1 en ohms ($\Omega$) ou sa conductance G en siemens (S) qui est l'inverse de l'impédance R1.

Ainsi, comme illustrée sur la Fig. 2, on peut à l'aide de la cellule de conductivité 40, d'un générateur de tension V et d'un ampèremètre A branché en série, déduire l'impédance R1 du liquide de nébulisation à l'aide de la loi d'Ohm :

U=R1.i avec U, la tension appliquée aux bornes de la cellule de conductivité 40, en volts (V), $R1$ en ohms ($\Omega$), i en ampères (A).

Dans un exemple non limitatif, l'électrode E1 est une anode et est donc reliée au pôle + du générateur V, et l'électrode E2 est une cathode et est donc reliée au pôle - du générateur de tension V.

On a la formule suivante :

$$\sigma . R1 = \frac{D}{S}$$

avec $S$ en centimètre carré (cm$^2$), D en centimètre (cm) et $\sigma$ en siemens par centimètre (S/cm).

La conductivité $\sigma$ est caractéristique du liquide de nébulisation L et est donc fonction de l'impédance R1 et d'une constante géométrique K (cm$^{-1}$) de la cellule de conductivité 40, appelé coefficient de conductivité avec :

$$K = \frac{D}{S}$$

Dans des exemples non limitatifs, à 25°C, la conductivité $\sigma$ est égale à :

- 0,05$\mu$S/cm pour une solution la plus pure ;
- 1 $\mu$S/cm pour une eau déionisée ;
- entre 10 $\mu$S/cm et 100$\mu$S/cm pour une eau distillée ;
- 50 $\mu$S/cm pour une eau de pluie ;
- entre 50 $\mu$S/cm et 1100 $\mu$S/cm pour une eau non corrosive ;
- 5 mS/cm pour une eau de rejet industriel ;
- 50 mS/cm pour une eau de mer.

La conductivité $\sigma$ mesure la concentration d'ions dans une solution, ici le liquide de nébulisation L. Plus il y a d'ions, plus la conductivité $\sigma$ est élevée, et plus la solution est polluée. Cela signifie qu'il y a notamment un taux élevé de sels et/ou d'acides.

Autrement dit, plus l'impédance R1 est petite et plus le liquide de nébulisation est pollué. Par contre, plus l'impédance R1 est grande et plus le liquide de nébulisation est propre et tend vers la pureté.

On notera qu'en l'absence de liquide de nébulisation L, l'impédance R1 de la cellule de conductivité est égale à l'infini.

Dans un mode de réalisation non limitatif, la cellule de conductivité 40 est couplée à une unité de calcul 60 adaptée pour déterminer le carbone organique total COT dans le liquide de nébulisation L. En effet, à partir de deux mesures de conductivité (une effectuée avant dégradation, et l'autre après dégradation), on détermine le carbone organique total COT.

Dans un mode de réalisation non limitatif, l'unité de calcul 60 comprend à cet effet un microprocesseur.

Le carbone organique total COT est mesuré en général en ppm (partie par million), ou en ppb (« part per billion » en langue anglaise ou partie par milliard en français) pour de l'eau ultra-pure par exemple, ou encore en mg/L (milligrammes par litre) pour un liquide plus conducteur tel que de l'eau potable par exemple. Il permet de donner la teneur en carbone des composés organiques dissous et non-dissous dans un liquide, ici le liquide de nébulisation L. Dans un mode de réalisation non limitatif, le COT est déterminé par oxydation du liquide de nébulisation, comme décrit ci-après. Les composés organiques de carbone O sont nocifs pour les occupants d'un véhicule automobile V car ils peuvent notamment signifier la présence de bactéries dans le liquide nébulisation L. L'oxydation permet notamment de décomposer les composés organiques nocifs tels que les bactéries. L'oxydation se fait au moyen de l'unité de dégradation 30 décrite ci-après.

Dans un mode de réalisation non limitatif, le dispositif de nébulisation 1 comprend en outre un microcontrôleur avec un convertisseur analogique numérique intégré couplé à ladite au moins une cellule de conductivité 40, ledit microcontrôleur effectuant la fonction d'activation/désactivation du nébuliseur 20 (décrite ci-après) et la commande des électrovannes (décrites ci-après).

Dans un autre mode de réalisation non limitatif, le dispositif de nébulisation 1 comprend en outre un convertisseur analogique numérique couplé à ladite au moins une cellule de conductivité 40 qui envoie ses données à une des unités centrales du véhicule automobile, cette dernière effectuant la fonction d'activation/désactivation du nébuliseur 20 (décrite ci-après) et la commande des électrovannes (décrites ci-après).

On notera que ce qui a été décrit ci-dessus pour la cellule de conductivité 40 s'applique également à la deuxième cellule de conductivité 41 (décrite plus loin dans la description).

• <u>Unité de dégradation de composés organiques</u>

Le terme « composé organique » désigne tout composé contenant au moins l'élément carbone et un ou plusieurs des éléments suivants : hydrogène, halogènes, oxygène, soufre, phosphore, silicium ou azote, à l'exception des oxydes de carbone 14 et des carbonates et bicarbonates inorganiques.

Dans un mode de réalisation non limitatif, l'unité de dégradation 30 est une lampe à ultra-violet. Dans une variante de réalisation non limitative, la lampe est une lampe à diode(s) électroluminescente(s) telle qu'une LED (« Light Emitting Diode ») dans un exemple non limitatif.

Dans un mode de réalisation non limitatif, la lampe à ultra-violet est réglée pour émettre des ondes électromagnétiques d'une longueur d'onde comprise entre 184 nanomètres et 254 nanomètres. Cette plage de valeur permet la formation de radicaux libres d'hydroxyle .OH décrits plus loin et permet ainsi de détruire de façon optimale les molécules organiques des composés organiques O. Dans une variante de réalisation non limitative, la lampe à ultra-violet est réglée sur une longueur d'onde de 254 nanomètres. Cela facilite la photo-oxydation, car cette longueur d'onde est plus énergétique que celle de 184 nm par exemple.

Ainsi, grâce à la lumière ultraviolette, l'unité de dégradation 30 permet de décomposer par photo-oxydation les composés organiques O présents dans le liquide de nébulisation L ce qui produit notamment du dioxyde de carbone $CO_2$.

En effet, l'exposition aux ultra-violets (UV) du liquide de nébulisation L, et en particulier de l'eau, entraîne la formation de radicaux libres d'hydroxyle .OH. Ces derniers cassent les liaisons covalentes des molécules de carbone des composés organiques O et oxydent lesdits composés organiques, produisant ainsi du dioxyde de carbone $CO_2$. Le dioxyde de carbone $CO_2$ étant soluble dans l'eau $H_2O$, la dissolution du $CO_2$ dans l'eau $H_2O$ va former de l'acide carbonique $H_2CO_3$. Ce dernier se dissocie dans l'eau $H_2O$ en ion d'hydrogène H+ et ion hydrogénocarbonate $HCO_3$-.

Ainsi, en raison de l'oxydation, la quantité d'ions dans le liquide de nébulisation L augmente ce qui modifie la conductivité $\sigma$ du liquide de nébulisation L. Du fait des propriétés du $CO_2$ et de $H_2CO_3$ dans le liquide de nébulisation L, la modification de la conductivité $\sigma$ du liquide de nébulisation L est ainsi liée au carbone organique total COT. Ainsi, en mesurant un changement de conductivité $\sigma$, on peut par corrélation en déduire le COT.

La cellule de conductivité 40 est couplée à l'unité de calcul 60 qui est adaptée pour déterminer le carbone organique total COT en fonction d'une différence $\Delta$ de mesures de conductivité $\sigma$.

La détermination du carbone organique total COT est effectuée par la corrélation entre la différence $\Delta$ et le COT. Lorsque le liquide de nébulisation L est exposé aux UV, et s'il comporte des composés organiques O, le COT diminue et la conductivité $\sigma$ du liquide de nébulisation L augmente.

On notera qu'une table de corrélation pour de l'eau potable peut être établie au préalable par expérimentation et utilisée pour ladite corrélation.

Soit la détermination du COT est effectuée :

- de manière continue pendant que la dégradation s'effectue ; ou
- toutes les N secondes (N ≥1), voire N minutes (N ≥1).

Ainsi, si d'après la corrélation, le liquide de nébulisation L comporte un carbone organique total COT supérieur à un seuil prédéterminé S, cela signifie que le liquide est de mauvaise qualité et ne peut être utilisé pour la nébulisation. Le nébuliseur 20 est alors désactivé (en particulier s'il était dans un état activé). Par conséquent, le diffuseur 14 n'envoie plus de gouttelettes dans l'habitacle du véhicule V.

Par contre, si d'après la corrélation, le liquide de nébulisation L comporte un carbone organique total COT inférieur ou égal audit seuil prédéterminé S, cela signifie que le liquide est de bonne qualité et peut être utilisé pour la nébulisation. Le nébuliseur 20 demeure donc dans l'état précédent dans lequel il était, à savoir soit activé, soit désactivé. Par conséquent, le diffuseur 14 envoie toujours des gouttelettes dans l'habitacle du véhicule V s'il était préalablement dans un état activé.

On notera que si le COT repasse au-dessous du seuil prédéterminé S, alors le nébuliseur 20 est réactivé s'il était auparavant activé. Cela signifie que les composés organiques O ont été suffisamment dégradés et le liquide de nébulisation L est redevenu de bonne qualité pour être utilisé.

Dans un mode de réalisation non limitatif, le seuil prédéterminé S est égal à 2 mg/L (milligrammes par litre). Ce seuil prédéterminé S correspond ainsi à la valeur limite de conductivité $\sigma$ du liquide de nébulisation L au-delà de laquelle ledit liquide de nébulisation L n'est plus d'assez bonne qualité pour la nébulisation, à savoir dans le cas de l'eau potable, à la valeur 1100 $\mu$S/cm (à 25°C).

Dans un mode de réalisation non limitatif, le dispositif de nébulisation 1 comprend en outre des moyens d'alerte (non illustrés) adaptés pour être déclenchés si le liquide de nébulisation L comporte un carbone organique total COT supérieur audit seuil prédéterminé S. Ces moyens d'alerte permettent d'informer l'utilisateur du véhicule automobile qu'il faut par exemple changer le liquide de nébulisation L. Ces moyens d'alerte sont notamment utiles lorsque l'effet de l'unité de dégradation 30 n'est plus assez efficace pour dépolluer le liquide de nébulisation L, à savoir lorsqu'au bout d'un certain temps, il y a toujours une augmentation de conductivité $\sigma$.

On notera que si après activation de l'unité de dégradation 30, il n'existe pas de différence $\Delta$ de mesures de conductivité $\sigma$, ou si la conductivité diminue, alors on en déduit que le liquide de nébulisation L ne comporte pas ou plus de composés organiques. Dans ce cas, cela signifie que le liquide de nébulisation L est de bonne qualité et peut être utilisé pour la nébulisation. Le nébuliseur 20 demeure donc dans l'état précédent dans lequel il

état, à savoir soit activé, soit désactivé. Par conséquent, le diffuseur 14 envoie toujours des gouttelettes dans l'habitacle du véhicule V s'il était préalablement dans un état activé.

Différents modes de réalisation du dispositif de nébulisation 1 sont décrits ci-après.

• Premier mode de réalisation non limitatif.

La figure 1 illustre un premier mode de réalisation non limitatif du dispositif de nébulisation 1. Selon ce mode de réalisation, le dispositif de nébulisation 1 comprend :

- l'unité d'alimentation en liquide 10 décrite précédemment ;
- le nébuliseur 20 décrit précédemment ;
- l'unité de dégradation 30 décrite précédemment ; et
- la cellule de conductivité 40 décrite précédemment.

Le dispositif de nébulisation 1 comprend en outre :

- un réservoir 13 adapté pour recevoir le liquide de nébulisation L et relié à un conduit de circulation appelé conduit de dégradation 12 (dans lequel les composés organiques O du liquide de nébulisation L vont être dégradés) ;
- une pompe 50 couplée au réservoir 13.

Dans ce mode de réalisation, l'unité d'alimentation en liquide 10 est reliée au réservoir 13 via un conduit de liaison 15.

L'ensemble des éléments 13, 12, 50 forme ainsi une boucle de circulation B2 pour la dégradation des composés organiques O du liquide de nébulisation, tandis que l'ensemble 10, 11, 14 forme une boucle de circulation pour la nébulisation B1.

La boucle de circulation B2 est appelée boucle de recirculation dans la suite de la description, et La boucle de circulation B1 est appelée boucle de nébulisation dans la suite de la description.

La pompe 50 est adaptée pour pomper le liquide de nébulisation L dans le réservoir 13 et le diriger dans le conduit de dégradation 12. Ainsi, la pompe 50 fait circuler le liquide de nébulisation L dans la boucle de recirculation B2. Elle est également adaptée pour contrôler le débit de liquide de nébulisation L dans la boucle de recirculation B2.

La cellule de conductivité 40 est située à l'intérieur du conduit de dégradation 12. Elle est donc adaptée pour mesurer la conductivité σ du liquide de nébulisation L circulant dans ledit conduit de dégradation 12.

Dans des modes de réalisation non limitatifs, la cellule de conductivité 40 est disposée dans le conduit de dégradation 12 :

- a) en amont de l'unité de dégradation 30 tel qu'illustrée sur la figure 1 (par rapport au sens de circulation F1 du liquide de nébulisation L);
- b) en regard de ladite unité de dégradation 30 ; ou
- c) en aval de l'unité de dégradation 40 (par rapport au sens de circulation F1 du liquide de nébulisation L).

L'unité de dégradation 30 est couplée audit conduit de dégradation 12. Dans une première variante de réalisation non limitative illustrée sur la figure 1, l'unité de dégradation 30 est disposée à l'extérieur du conduit de dégradation 12. Dans l'exemple non limitatif illustré, ladite unité de dégradation 30 est en contact avec ledit conduit de dégradation 12.

Dans une deuxième variante de réalisation non limitative, l'unité de dégradation 30 est disposée à l'intérieur du conduit de dégradation 12, de sorte que le liquide de nébulisation L s'écoule tout autour de ladite unité de dégradation 30.

Dans le cas a) illustré à la figure 1, le liquide de nébulisation L suit le chemin d'écoulement suivant dans la boucle de recirculation B2 :

- du réservoir 13 vers la cellule de conductivité 40 (en passant par la pompe 50). Cette dernière permet de mesurer la conductivité σ du liquide de nébulisation L avant son passage devant l'unité de dégradation 30 (lorsque le liquide de nébulisation L circule dans le sens indiqué par la flèche F1 et le chemin 13, 50, 40, 30, 13) ;
- de la cellule de conductivité 40 vers l'unité de dégradation 30.
- de l'unité de dégradation 30 vers le réservoir 13.

Ainsi, lorsque pour la première fois l'unité de dégradation 30 est activée :

- la cellule de conductivité 40 effectue une première mesure M1 de conductivité σ sur un liquide de nébulisation L avant la dégradation des composés organiques O par ladite unité de dégradation 30 ; puis
- le liquide de nébulisation L subit une oxydation. Les composés organiques O sont dégradés ; puis
- lorsque le liquide de nébulisation L refait un tour dans la boucle de recirculation B2, la cellule de conductivité 40 effectue une deuxième mesure M2 de conductivité σ sur un liquide de nébulisation L après la dégradation des composés organiques O par ladite unité de dégradation 30.

A chaque tour de boucle de recirculation secondaire B2 suivante, la cellule de conductivité 40 effectue une première mesure M1 de conductivité σ et une deuxième mesure M2 de conductivité σ, cette fois-ci sur le liquide de nébulisation L dont les composants organiques O ont subi au moins une dégradation par l'unité de dégradation 30, à savoir ont été exposés au moins une fois aux UV de l'unité de dégradation 30. A chaque tour de boucle de recirculation B2 suivante, la deuxième mesure M2 de conductivité σ est effectuée sur le liquide de nébulisation L qui a subi une oxydation supplémentaire par rapport à la première mesure M1 de conductivité σ.

Dans ce premier mode de réalisation, l'unité de calcul 60 est couplée à la cellule de conductivité 40. Ainsi, l'unité de calcul 60 détermine le carbone organique total COT en fonction de la différence Δ des deux mesures M1, M2 de conductivité σ effectuées par la cellule de conductivité 40. La valeur du COT est ainsi proportionnelle à la différence Δ de deux mesures de conductivité effectuées par la cellule de conductivité 40.

Si d'après la corrélation, le COT déterminé est supérieur au seuil prédéterminé S, le nébuliseur 20 est alors désactivé (s'il était activé). Son activation est donc interdite :

-   tant que le COT est supérieur au seuil prédéterminé S, le nébuliseur 20 reste désactivé. Le liquide de nébulisation L n'est pas d'assez bonne qualité pour être diffusé dans l'habitacle du véhicule automobile V.
-   dès que le COT est inférieur ou égal au seuil prédéterminé S, le nébuliseur 20 peut être activé. Les composants organiques de carbone O ayant été dégradés de façon suffisante, le liquide de nébulisation L est maintenant d'assez bonne qualité pour être diffusé dans l'habitacle du véhicule automobile V.

Si d'après la corrélation, le COT déterminé est inférieur ou égal audit seuil prédéterminé S, le nébuliseur 20 demeure donc dans l'état précédent dans lequel il était.

On notera que lorsque le nébuliseur 20 est désactivé, le liquide de nébulisation L ne peut normalement aller du réservoir 13 à l'unité d'alimentation en liquide 10. On notera que lorsque le nébuliseur 20 est activé (à savoir l'élément piézo-électrique 200 fonctionne ainsi que le diffuseur 14), le liquide de nébulisation L peut aller du réservoir 13 à l'unité d'alimentation en liquide 10 par aspiration du fait des vibrations émises par l'élément piézo-électrique 200.

Dans un mode de réalisation non limitatif, on peut prévoir une électrovanne à deux voies (non illustrée) disposée entre le réservoir 13 et le conduit de liaison 15 qui ne laisse passer le liquide de nébulisation L dans ledit conduit de liaison 15 que si le COT est inférieur ou égal au seuil prédéterminé S. Ainsi, le fonctionnement de cette électrovanne (ouverture/fermeture d'une voie) s'effectue en fonction du résultat de la comparaison entre le COT déterminé et le seuil prédéterminé S.

Le dispositif de nébulisation est décrit selon plusieurs autres modes de réalisation non limitatifs ci-après. Selon ces modes, deux cellules de conductivité 40, 41 sont utilisées, ce qui permet d'obtenir une mesure plus fine du carbone organique total COT que dans le cas d'utilisation d'une seule cellule de conductivité.
En effet, dans le cas d'utilisation avec une seule cellule de conductivité, on intègre dans la différence Δ de mesures de conductivité la longueur de la boucle de recirculation B2 et par conséquent la conductivité peut être légèrement augmentée par combinaison avec les matériaux contenus dans le conduit de dégradation 12, dans le réservoir 13 et avec l'air contenu dans le réservoir 13 du liquide de nébulisation L. Les ions contenus dans les plastiques et dans l'air peuvent être combinés avec le liquide de nébulisation L. Donc il peut avoir une légère augmentation de la conductivité entre la mesure effectuée avant dégradation par l'unité de dégradation 30 et après dégradation par l'unité de dégradation 30 sans aucun lien avec la dégradation des composés organiques.

On notera que dans la description des modes de réalisation ci-dessous, la cellule de conductivité 40 sera appelée première cellule de conductivité, et la cellule de conductivité 41 sera appelée deuxième cellule de conductivité.

• Deuxième mode de réalisation non limitatif

La figure 3 illustre un deuxième mode de réalisation non limitatif du dispositif de nébulisation 1.
Ce deuxième mode reprend l'ensemble des éléments du premier mode de réalisation, à savoir :

-   l'unité d'alimentation en liquide 10 décrite précédemment ;
-   le nébuliseur 20 décrit précédemment ;
-   l'unité de dégradation 30 décrite précédemment ;
-   la première cellule de conductivité 40 décrite précédemment.
-   le réservoir 13 décrit précédemment ; et
-   la pompe 50 décrite précédemment.

On notera que dans ce deuxième mode de réalisation :

-   l'unité de dégradation 30 est illustrée selon la deuxième variante de réalisation dans laquelle elle est intégrée dans le conduit de dégradation 12. Bien entendu, l'unité de dégradation 30 peut être également disposée à l'extérieur du conduit de dégradation 12 comme décrit précédemment ;
-   une électrovanne à deux voies 71 est disposée entre le réservoir 13 et le conduit de liaison 15 qui est adaptée pour ne laisser passer le liquide de nébulisation L dans ledit conduit de liaison 15 que si le COT est inférieur ou égal au seuil prédéterminé S. Bien entendu, un conduit de liaison 15 seul peut également être utilisé comme décrit précédemment.

L'ensemble des éléments 13, 12, 50 forme ainsi une boucle de recirculation B2, tandis que l'ensemble 10, 11, 14 forme une boucle de nébulisation B1.

Le dispositif de nébulisation 1 comprend en outre une deuxième cellule de conductivité 41 adaptée pour mesurer la conductivité σ du liquide de nébulisation après le passage du liquide de nébulisation L devant ladite unité de dégradation 30 (lorsque le liquide de nébulisation L circule dans le sens indiqué par la flèche F1 et le chemin 13, 50, 40, 30, 41, 13).

Ainsi, comme on peut le voir sur la figure 3, la deuxième cellule de conductivité 41 est disposée à l'intérieur du conduit de dégradation 12 et en aval de l'unité de dégradation 30 par rapport au sens de circulation F1 du liquide de nébulisation L.

Le liquide de nébulisation L suit le chemin d'écoulement suivant dans la boucle de recirculation B2 :

- du réservoir 13 vers la première cellule de conductivité 40 (en passant par la pompe 50) ;
- de la première cellule de conductivité 40 vers l'unité de dégradation 30 ;
- de l'unité de dégradation 30 vers la deuxième cellule de conductivité 41 ;
- de la deuxième cellule de conductivité 41 vers le réservoir 13.

Ainsi, lorsque pour la première fois l'unité de dégradation 30 est activée :

- la première cellule de conductivité 40 effectue une première mesure M1 de conductivité σ sur un liquide de nébulisation L avant la dégradation des composés organiques O par l'unité de dégradation 30 ; puis
- le liquide de nébulisation L s'écoule autour de ladite unité de dégradation 30 et subit une oxydation. Les composés organiques O sont dégradés ;
- la deuxième cellule de conductivité 41 effectue une deuxième mesure M2 de conductivité σ sur un liquide de nébulisation L après la dégradation des composés organiques par l'unité de dégradation 30.

A chaque tour de boucle de recirculation B2 suivante, la première cellule de conductivité 40 effectue une première mesure M1 de conductivité σ cette fois-ci sur le liquide de nébulisation L dont les composants organiques O ont subi au moins une dégradation par l'unité de dégradation 30, à savoir ont été exposés au moins une fois aux UV de l'unité de dégradation 30. A chaque tour de boucle de recirculation B2 suivante, la deuxième mesure M2 de conductivité σ est effectuée par la deuxième cellule de conductivité 41 sur le liquide de nébulisation L qui a subi une oxydation supplémentaire par rapport à la première mesure M1 de conductivité σ.

Dans ce deuxième mode de réalisation, l'unité de calcul 60 est couplée à la première cellule de conductivité 40 et à la deuxième cellule de conductivité 41. Ainsi, l'unité de calcul 60 détermine le carbone organique total COT en fonction de la différence de mesures Δ entre une mesure M1 de conductivité σ par la première cellule de conductivité 40 et une mesure M2 de conductivité σ par la deuxième cellule de conductivité 41. La valeur du COT est ainsi proportionnelle à la différence Δ des mesures de conductivité σ du liquide de nébulisation L par les deux cellules de conductivité 40 et 41.

De même que pour le premier mode de réalisation, la détermination du COT est effectuée par la corrélation entre la valeur de la différence Δ et le COT.

De même que pour le premier mode de réalisation, si d'après la corrélation, le COT déterminé est supérieur au seuil prédéterminé S, le nébuliseur 20 est alors désactivé (s'il était activé). Son activation est donc interdite. Et, si d'après la corrélation, le COT déterminé est inférieur ou égal audit seuil prédéterminé S, le nébuliseur 20 demeure donc dans l'état précédent dans lequel il était.

- Troisième mode de réalisation non limitatif.

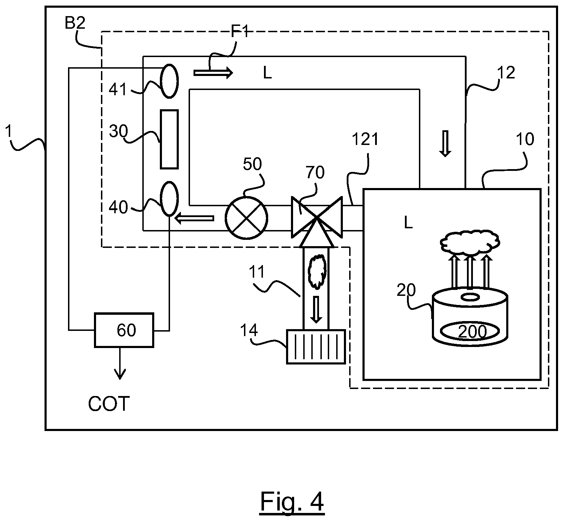

La figure 4 illustre un troisième mode de réalisation non limitatif du dispositif de nébulisation 1. Selon ce mode de réalisation, le dispositif de nébulisation 1 comprend :

- le nébuliseur 20 décrit précédemment ;
- l'unité de dégradation 30 décrite précédemment ;
- la première cellule de conductivité 40 décrite précédemment ; et
- la deuxième cellule de conductivité 41 décrite précédemment dans le deuxième mode.

Le dispositif de nébulisation 1 comprend en outre :

- une unité d'alimentation en liquide 10 du nébuliseur 20 reliée à un conduit de dégradation 12 et adaptée pour recevoir un liquide de nébulisation L ; et
- une pompe 50 couplée ici à ladite unité d'alimentation en liquide 10 ; et
- une électrovanne 70 reliée au conduit de dégradation 12 et au conduit de nébulisation 11. L'électrovanne 70 est en outre reliée à l'unité d'alimentation en liquide 10 via une partie 121 du conduit de dégradation 12.

Ainsi, comme on peut le voir, le réservoir 13 décrit dans le deuxième mode a été ici supprimé et remplacé par l'unité d'alimentation en liquide 10.

L'ensemble des éléments 10, 12, 50, 70 forme ainsi une boucle de recirculation B2 et l'ensemble des éléments 10, 11, 14, 70 forme une boucle de nébulisation B1. L'unité d'alimentation 10 fait ainsi partie de la boucle de recirculation B2 et de la boucle de nébulisation B1.

La pompe 50 est adaptée pour pomper le liquide de nébulisation L dans l'unité d'alimentation en liquide 10 et le diriger dans le conduit de dégradation 12. Ainsi, elle fait circuler le liquide de nébulisation L dans la boucle de recirculation B2. Elle est également adaptée pour contrôler le débit de liquide de nébulisation L dans la boucle de recirculation B2.

Dans ce cas, le liquide de nébulisation L suit le chemin d'écoulement suivant dans la boucle de recirculation B2 :

- de l'unité d'alimentation en liquide 10 vers la première cellule de conductivité 40 (en passant par la partie 121 du conduit de dégradation 12, par l'électrovanne 70 et par la pompe 50) ;
- de la première cellule de conductivité 40 vers l'unité de dégradation 30 ;
- de l'unité de dégradation 30 vers la deuxième cellule de conductivité 41 ;
- de la deuxième cellule de conductivité 41 vers l'unité d'alimentation en liquide 10.

La partie concernant l'unité de calcul 60 décrite précédemment dans le deuxième mode de réalisation est également applicable dans ce troisième mode de réalisation.

De même que pour le premier ou le deuxième mode de réalisation, tant que le COT est supérieur au seuil prédéterminé S (2 mg/L dans un mode de réalisation non limitatif), le nébuliseur 20 est désactivé. Dès que le COT est inférieur ou égal au seuil prédéterminé S, le nébuliseur 20 peut être activé.

Dans un mode de réalisation non limitatif, l'électrovanne 70 est à deux voies. Dans l'exemple non limitatif illustré, l'électrovanne 70 est disposée entre l'unité d'alimentation en liquide 10 et la pompe 50.

Le fonctionnement de l'électrovanne 70 (ouverture/fermeture d'une voie) s'effectue en fonction du résultat de la comparaison entre le COT déterminé et le seuil prédéterminé S.

Elle est adaptée pour :

- diriger le liquide de nébulisation L nébulisé (à savoir les fines gouttelettes) de l'unité d'alimentation en liquide 10 vers le diffuseur 14 via le conduit de nébulisation 11 si le carbone organique total COT est inférieur ou égal au seuil prédéterminé S ; ou
- diriger le liquide de nébulisation L de l'unité d'alimentation en liquide 10 vers le conduit de dégradation 12 si le carbone organique total COT est supérieur au seuil prédéterminé S ; et
- arrêter d'alimenter en liquide de nébulisation L nébulisé le diffuseur 14 (et donc le conduit de nébulisation 11) si le carbone organique total COT est supérieur au seuil prédéterminé S.

On notera que dans ce troisième mode de réalisation, lorsque le nébuliseur 20 est activé, dans ce cas l'unité de dégradation 30 est désactivée ; et lorsque l'unité de dégradation 30 est activée, le nébuliseur 20 est désactivé. Ainsi, soit la partie 121 du conduit de dégradation 12 transporte du liquide de nébulisation L vers l'électrovanne 70 pour la boucle de recirculation B2, soit elle transporte des gouttelettes fines produites par le nébuliseur 20 vers l'électrovanne 70 pour la première boucle de nébulisation B1.

Comme vu précédemment, la conductivité $\sigma$ du liquide de nébulisation L dépend de la concentration des ions dans le liquide de nébulisation L.

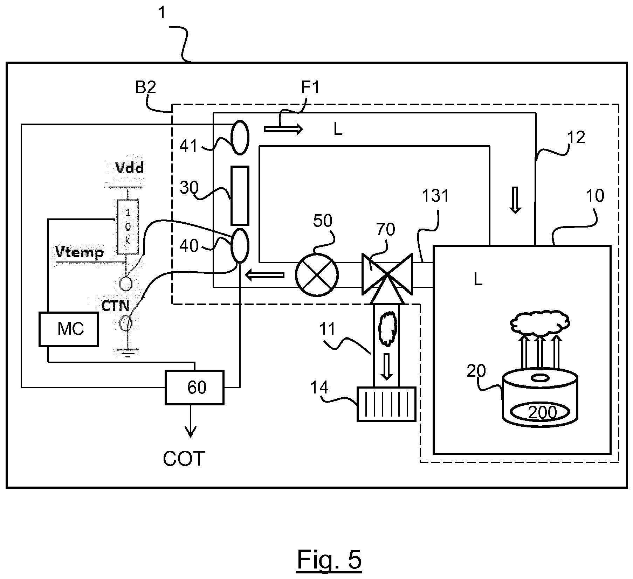

Par ailleurs, la conductivité $\sigma$ dépend également de la température du liquide de nébulisation L. Si la température augmente, la conductivité $\sigma$ augmente également. Pour être comparables entre elles, les mesures de conductivité sont souvent ramenées à une température de référence Tref, en général 20 °C ou 25 °C. Aussi, tel qu'illustré sur la figure 5 (qui se base sur la figure 4), dans un mode de réalisation non limitatif, ledit dispositif de nébulisation 1 comprend en outre :

- un capteur de température CTN disposé aux bornes des deux électrodes E1, E2 d'au moins une des cellules de conductivité 40/41 et adapté pour fournir une température réelle Tm du liquide de nébulisation L ;
- des moyens de correction MC (tels qu'illustrés sur la figure 5) de la conductivité mesurée $\sigma$ pour ramener la conductivité mesurée $\sigma$ à la température de référence Tref. Dans un mode de réalisation non limitatif, les moyens de correction sont un microcontrôleur.

Dans l'exemple non limitatif illustré sur la figure 5, le capteur de température CTN est relié à la première cellule de conductivité 40. Il peut également être relié à la deuxième cellule de conductivité 41 ou aux deux cellules de conductivité 40 et 41.

Dans un mode de réalisation non limitatif, la conductivité mesurée $\sigma$ à la température réelle Tm du liquide de nébulisation L est ramenée à 25°C (nouvelle valeur de conductivité $\sigma25$) à l'aide d'une approximation linéaire de 2% par degré Celsius sur la résistivité $\rho$ qui est la suivante :

$\rho(25°C) = \rho\,(1+0.02*(Tm-25))$, avec $\rho(25°C)$ la résistivité du liquide de nébulisation L compensée en température $(\Omega).cm@25°C$.

On rappelle que la résistivité $\rho$ (en ohms par centimètre $(\Omega.cm)$ est l'inverse de la conductivité $\sigma$.

Bien entendu le capteur CTN peut être utilisé dans tous les modes de réalisation décrits précédemment et ci-après.

• Quatrième mode de réalisation non limitatif

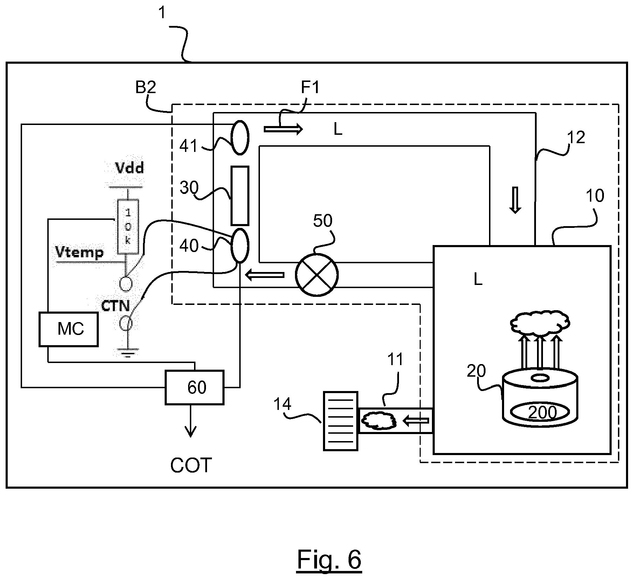

La figure 6 illustre un quatrième mode de réalisation non limitatif du dispositif de nébulisation 1. Selon ce mode de réalisation, le dispositif de nébulisation 1 comprend :

- le nébuliseur 20 décrit précédemment ;
- l'unité de dégradation 30 décrite précédemment ;
- la première cellule de conductivité 40 décrite précédemment ; et
- la deuxième cellule de conductivité 41 décrite précédemment dans le troisième mode de réalisation ;

- une pompe 50 couplée à ladite unité d'alimentation en liquide 10 décrite précédemment dans le troisième mode de réalisation ;

Le dispositif de nébulisation 1 comprend en outre :

- une unité d'alimentation en liquide 10 du nébuliseur 20 reliée à un conduit de dégradation 12, reliée à un diffuseur 14 via un conduit de nébulisation 11, et adaptée pour recevoir un liquide de nébulisation L.

Ainsi, par rapport au troisième mode de réalisation décrit précédemment, l'électrovanne 70 décrite dans le troisième mode a été supprimée et le conduit de nébulisation 11 est ici directement relié à l'unité d'alimentation en liquide 10.

L'ensemble des éléments 10, 12, 50 forme ainsi une boucle de recirculation B2 et l'ensemble des éléments 10, 11, 14 forme une boucle de nébulisation B1. L'unité d'alimentation 10 fait ainsi partie de la boucle de recirculation B2 et de la première boucle de nébulisation B1.

Le liquide de nébulisation L suit le chemin d'écoulement suivant dans la boucle de recirculation B2 :

- de l'unité d'alimentation en liquide 10 vers la première cellule de conductivité 40 (en passant par la pompe 50) ;
- de la première cellule de conductivité 40 vers l'unité de dégradation 30 ;
- de l'unité de dégradation 30 vers la deuxième cellule de conductivité 41 ;
- de la deuxième cellule de conductivité 41 vers l'unité d'alimentation en liquide 10.

La partie concernant l'unité de calcul 60 décrite précédemment dans les trois premiers modes de réalisation est également applicable dans ce quatrième mode de réalisation.

De même que pour le premier, le deuxième ou le troisième mode de réalisation, si d'après la corrélation, le COT déterminé est supérieur au seuil prédéterminé S, le nébuliseur 20 est alors désactivé (s'il était activé). Son activation est donc interdite. Et, si d'après la corrélation, le COT déterminé est inférieur ou égal audit seuil prédéterminé S, le nébuliseur 20 demeure donc dans l'état précédent dans lequel il était.

On notera que dans ce quatrième mode de réalisation, la nébulisation peut fonctionner en même temps que la dégradation des composés organiques par oxydation s'effectue. Ainsi, lorsque l'unité de dégradation 30 est activée, le nébuliseur 20 peut également être activé. Ainsi, le conduit de dégradation 12 peut transporter du liquide de nébulisation L pour la boucle de recirculation B2 pendant que le conduit de nébulisation 11 transporte des gouttelettes fines produites par le nébuliseur 20 pour la boucle de nébulisation B1.

Bien entendu la description de l'invention n'est pas limitée aux modes de réalisation décrits ci-dessus. Ainsi, dans des modes de réalisation non limitatifs :

- la pompe 50 peut être placée entre la première cellule de conductivité 40 et l'unité de dégradation 30 ;
- la pompe 50 peut être placée entre l'unité d'alimentation 10 et l'électrovanne 70.

Ainsi, dans un mode de réalisation non limitatif, plusieurs capteurs de température CTN peuvent être utilisés, par exemple un capteur de température CTN couplé à chaque cellule de conductivité 40 et 41.

Ainsi, dans un autre mode de réalisation non limitatif, la conductivité mesurée $\sigma$ à la température réelle Tm du liquide de nébulisation L est ramenée à 25°C (nouvelle valeur de conductivité $\sigma25$) à l'aide d'une équation qui est la suivante : $\sigma25 = f25(T)^*\sigma$, avec f25(T) un facteur de correction de température calculé selon une équation décrite dans la norme ISO/DIN/7888 (applicable aux eaux naturelles).

Ainsi, l'invention décrite présente notamment les avantages suivants :

- c'est une solution simple à mettre en œuvre et peu coûteuse ;
- elle permet de mesurer le carbone organique total COT du liquide de nébulisation ;
- elle permet d'obtenir un liquide de nébulisation de meilleure qualité ;
- elle permet d'arrêter la nébulisation si le liquide de nébulisation comprend trop de composés organiques.

**Revendications**

1. Dispositif de nébulisation (1) pour véhicule automobile (V), selon lequel le dispositif de nébulisation (1) comprend :

   - un nébuliseur (20) adapté pour effectuer une nébulisation d'un liquide de nébulisation (L) ;
   - une unité de dégradation (30) adaptée pour dégrader des composés organiques (O) dans ledit liquide de nébulisation (L) ;
   - au moins une cellule de conductivité (40) adaptée pour mesurer la conductivité ($\sigma$) du liquide de nébulisation (L),
   - **caractérisé en ce que** au moins une cellule de conductivité (40, 41) est couplée à une unité de calcul (60) adaptée pour déterminer le carbone organique total (COT) dans ledit liquide de nébulisation (L).

2. Dispositif nébulisation (1) selon la revendication 1, selon lequel l'unité de dégradation (30) est une lampe à ultra-violets.

3. Dispositif nébulisation (1) selon l'une quelconque des revendications précédentes 1 à 2, selon lequel ladite au moins une cellule de conductivité (40) est adaptée pour mesurer la conductivité ($\sigma$) du liquide de nébulisation (L) avant le passage du liquide de nébulisation (L) devant ladite unité de dégradation (30).

4. Dispositif de nébulisation (1) selon l'une quelconque des revendications précédentes 1 à 3, selon lequel ledit dispositif de nébulisation (1) comprend en outre une deuxième cellule de conductivité (41) adaptée pour mesurer la conductivité ($\sigma$) du liquide de nébulisation après le passage du liquide de nébulisation (L) devant ladite unité de dégradation (30).

5. Dispositif de nébulisation (1) selon l'une quelconque des revendications précédentes, selon lequel le carbone organique total (COT) est déterminé en fonction d'une différence ($\Delta$) de mesures de conductivité ($\sigma$) par une cellule de conductivité (40).

6. Dispositif de nébulisation (1) selon l'une quelconque des revendications précédentes, selon lequel le carbone organique total (COT) est déterminé en fonction d'une différence ($\Delta$) de mesures de conductivité ($\sigma$) par deux cellules de conductivité (40, 41).

7. Dispositif de nébulisation (1) selon l'une quelconque des revendications précédentes, selon lequel si le liquide de nébulisation (L) comporte un carbone organique total (COT) supérieur à un seuil prédéterminé (S), le nébuliseur (20) est désactivé.

8. Dispositif de nébulisation (1) selon l'une quelconque des revendications précédentes, selon lequel le dispositif de nébulisation (1) comprend en outre des moyens d'alerte adaptés pour être déclenchés si le liquide de nébulisation (L) comporte un carbone organique total (COT) supérieur à un seuil prédéterminé (S).

9. Dispositif de nébulisation (1) selon l'une quelconque des revendications précédentes, selon lequel ledit dispositif de nébulisation (1) comprend en outre :

     - une unité d'alimentation en liquide (10) du nébuliseur (20) adaptée pour recevoir un liquide de nébulisation (L) ;
     - un réservoir (13) adapté pour recevoir le liquide de nébulisation (L) et relié à un conduit de dégradation(12) ;
     - une pompe (50) couplée audit réservoir (13).

10. Dispositif de nébulisation (1) selon l'une quelconque des revendications précédentes 1 à 8, selon lequel ledit dispositif de nébulisation (1) comprend en outre :

     - une unité d'alimentation en liquide (10) du nébuliseur (20) reliée à un conduit de dégradation (12) et adaptée pour recevoir un liquide de nébulisation (L) ;
     - une pompe (50) couplée à ladite unité d'alimentation en liquide (10).

11. Dispositif de nébulisation (1) selon la revendication précédente 9 ou 10, selon lequel :

     - l'unité de dégradation (30) est couplée audit conduit de dégradation (12) ; et
     - ladite au moins une cellule de conductivité (40) est située à l'intérieur du conduit de dégradation (12).

12. Dispositif de nébulisation (1) selon la revendication précédente 10 ou 11, selon lequel le dispositif de nébulisation (1) comprend en outre une électrovanne (70) adaptée pour :

     - diriger le liquide de nébulisation (L) nébulisé de l'unité d'alimentation en liquide (10) vers un diffuseur (14) si le carbone organique total (COT) est inférieur ou égal à un seuil prédéterminé (S) ; ou
     - diriger le liquide de nébulisation (L) de l'unité d'alimentation en liquide (10) vers le conduit de dégradation (12) si le carbone organique total (COT) est supérieur au seuil prédéterminé (S) ; et
     - arrêter d'alimenter en liquide de nébulisation (L) nébulisé le diffuseur (14) si le carbone organique total (COT) est supérieur au seuil prédéterminé (S).

13. Dispositif de nébulisation (1) selon l'une quelconque des revendications précédentes 9 à 12, selon lequel l'unité de dégradation (30) est disposée à l'intérieur ou à l'extérieur du conduit de dégradation (12).

14. Dispositif de nébulisation (1) selon l'une quelconque des revendications 9 à 13, selon lequel ladite unité d'alimentation en liquide (10) est :

     - un réservoir de nébulisation ; ou
     - un conduit de nébulisation dans lequel le liquide de nébulisation (L) peut s'écouler.

**Patentansprüche**

1. Vernebelungsvorrichtung (1) für ein Kraftfahrzeug (V), wobei die Vernebelungsvorrichtung (1) umfasst:

     - einen Vernebler (20), der geeignet ist, eine Vernebelung einer Vernebelungsflüssigkeit (L) durchzuführen;

- eine Abbaueinheit (30), die geeignet ist, organische Verbindungen (O) in der Vernebelungsflüssigkeit (L) abzubauen;
- mindestens eine Leitfähigkeitszelle (40), die dazu geeignet ist, die Leitfähigkeit ($\sigma$) der Vernebelungsflüssigkeit (L) zu messen,
- **dadurch gekennzeichnet, dass** mindestens eine Leitfähigkeitszelle (40, 41) an die Recheneinheit (60) gekoppelt ist, die geeignet ist, den gesamten organischen Kohlenstoff (TOC) in der Vernebelungsflüssigkeit (L) zu bestimmen.

2.  Vernebelungsvorrichtung (1) nach Anspruch 1, wobei die Abbaueinheit (30) eine UV-Lampe ist.

3.  Vernebelungsvorrichtung (1) nach einem der vorhergehenden Ansprüche 1 bis 2, wobei die mindestens eine Leitfähigkeitszelle (40) geeignet ist, die Leitfähigkeit ($\sigma$) der Vernebelungsflüssigkeit (L) vor dem Vorbeiströmen der Vernebelungsflüssigkeit (L) vor der Abbaueinheit (30) zu messen.

4.  Vernebelungsvorrichtung (1) nach einem der vorhergehenden Ansprüche 1 bis 3, wobei die Vernebelungsvorrichtung (1) ferner eine zweite Leitfähigkeitszelle (41) umfasst, die geeignet ist, die Leitfähigkeit ($\sigma$) der Vernebelungsflüssigkeit nach dem Vorbeiströmen der Vernebelungsflüssigkeit (L) vor der Abbaueinheit (30) zu messen.

5.  Vernebelungsvorrichtung (1) nach einem der vorhergehenden Ansprüche, wobei der gesamte organische Kohlenstoff (TOC) in Abhängigkeit von einer Differenz ($\Delta$) von Leitfähigkeitsmessungen ($\sigma$) durch eine Leitfähigkeitszelle (40) bestimmt wird.

6.  Vernebelungsvorrichtung (1) nach einem der vorhergehenden Ansprüche, wobei der gesamte organische Kohlenstoff (TOC) in Abhängigkeit von einer Differenz ($\Delta$) von Leitfähigkeitsmessungen ($\sigma$) durch zwei Leitfähigkeitszellen (40, 41) bestimmt wird.

7.  Vernebelungsvorrichtung (1) nach einem der vorhergehenden Ansprüche, wobei, wenn die Vernebelungsflüssigkeit (L) einen gesamten organischen Kohlenstoff (TOC) über einem vorbestimmten Schwellenwert (S) enthält, der Vernebler (20) deaktiviert wird.

8.  Vernebelungsvorrichtung (1) nach einem der vorhergehenden Ansprüche, wobei die Vernebelungsvorrichtung (1) ferner Warneinrichtungen umfasst, die geeignet sind, ausgelöst zu werden, wenn die Vernebelungsflüssigkeit (L) einen gesamten organischen Kohlenstoff (TOC) über einem vorbestimmten Schwellenwert (S) enthält.

9.  Vernebelungsvorrichtung (1) nach einem der vorhergehenden Ansprüche, wobei die Vernebelungsvorrichtung (1) ferner umfasst:

- eine Flüssigkeitsversorgungseinheit (10) für den Vernebler (20), die geeignet ist, eine Vernebelungsflüssigkeit (L) aufzunehmen;
- einen Vorratsbehälter (13), der geeignet ist, die Vernebelungsflüssigkeit (L) aufzunehmen, und mit einer Abbauleitung (12) verbunden ist;
- eine Pumpe (50), die an den Vorratsbehälter (13) gekoppelt ist.

10. Vernebelungsvorrichtung (1) nach einem der vorhergehenden Ansprüche 1 bis 8, wobei die Vernebelungsvorrichtung (1) ferner umfasst:

- eine Flüssigkeitsversorgungseinheit (10) für den Vernebler (20), die mit einer Abbauleitung (12) verbunden ist und geeignet ist, eine Vernebelungsflüssigkeit (L) aufzunehmen;
- eine Pumpe (50), die an die Flüssigkeitsversorgungseinheit (10) gekoppelt ist.

11. Vernebelungsvorrichtung (1) nach dem vorhergehenden Anspruch 9 oder 10, wobei:

- die Abbaueinheit (30) an die Abbauleitung (12) gekoppelt ist; und
- die mindestens eine Leitfähigkeitszelle (40) innerhalb der Abbauleitung (12) gelegen ist.

12. Vernebelungsvorrichtung (1) nach dem vorhergehenden Anspruch 10 oder 11, wobei die Vernebelungsvorrichtung (1) ferner ein Magnetventil (70) umfasst, das geeignet ist:

- die vernebelte Vernebelungsflüssigkeit (L) von der Flüssigkeitsversorgungseinheit (10) zu einem Ausströmer (14) zu leiten, wenn der gesamte organische Kohlenstoff (TOC) kleiner als oder gleich einem vorbestimmten Schwellenwert (S) ist; oder
- die Vernebelungsflüssigkeit (L) von der Flüssigkeitsversorgungseinheit (10) zur Abbauleitung (12) zu leiten, wenn der gesamte organische Kohlenstoff (TOC) über dem vorbestimmten Schwellenwert (S) liegt; und
- die Versorgung des Ausströmers (14) mit vernebelter Vernebelungsflüssigkeit (L) zu stoppen, wenn der gesamte organische Kohlenstoff (TOC) über dem vorbestimmten Schwellenwert (S) liegt.

13. Vernebelungsvorrichtung (1) nach einem der vorhergehenden Ansprüche 9 bis 12, wobei die Abbaueinheit (30) innerhalb oder außerhalb der Abbauleitung (12) angeordnet ist.

**14.** Vernebelungsvorrichtung (1) nach einem der Ansprüche 9 bis 13, wobei die Flüssigkeitsversorgungseinheit (10) ist:

- ein Vernebelungsbehälter; oder
- eine Vernebelungsleitung, in der die Vernebelungsflüssigkeit (L) fließen kann.

**Claims**

**1.** Nebulization device (1) for a motor vehicle (V), in which the nebulization device (1) comprises:

- a nebulizer (20) suitable for performing a nebulization of a nebulization liquid (L);
- a degradation unit (30) suitable for degrading organic compounds (O) in said nebulization liquid (L) ;
- at least one conductivity cell (40) suitable for measuring the conductivity ($\sigma$) of the nebulization liquid (L),
- **characterized in that** at least one conductivity cell (40, 41) is coupled to a computation unit (60) suitable for determining the total organic carbon (TOC) in said nebulization liquid (L).

**2.** Nebulization device (1) according to Claim 1, wherein the degradation unit (30) is an ultraviolet lamp.

**3.** Nebulization device (1) according to either one of Claims 1 and 2 above, wherein said at least one conductivity cell (40) is suitable for measuring the conductivity ($\sigma$) of the nebulization liquid (L) before the nebulization liquid (L) passes in front of said degradation unit (30).

**4.** Nebulization device (1) according to any one of Claims 1 to 3 above, wherein said nebulization device (1) further comprises a second conductivity cell (41) suitable for measuring the conductivity ($\sigma$) of the nebulization liquid after the nebulization liquid (L) passes in front of said degradation unit (30).

**5.** Nebulization device (1) according to any one of the preceding claims, wherein the total organic carbon (TOC) is determined depending on a difference ($\Delta$) in conductivity measurements ($\sigma$) by a conductivity cell (40) .

**6.** Nebulization device (1) according to any one of the preceding claims, wherein the total organic carbon (TOC) is determined depending on a difference ($\Delta$) in conductivity measurements ($\sigma$) by two conductivity cells (40, 41).

**7.** Nebulization device (1) according to any one of the preceding claims, wherein, if the nebulization liquid (L) has a total organic carbon (TOC) higher than a predetermined threshold (S), the nebulizer (20) is deactivated.

**8.** Nebulization device (1) according to any one of the preceding claims, wherein the nebulization device (1) further comprises warning means suitable for being triggered if the nebulization liquid (L) has a total organic carbon (TOC) greater than a predetermined threshold (S).

**9.** Nebulization device (1) according to any one of the preceding claims, wherein said nebulization device (1) further comprises:

- a unit (10) for supplying liquid to the nebulizer (20), said unit being suitable for receiving a nebulization liquid (L);
- a reservoir (13) suitable for receiving the nebulization liquid (L) and connected to a degradation conduit (12);
- a pump (50) coupled to said reservoir (13).

**10.** Nebulization device (1) according to any one of Claims 1 to 8 above, wherein said nebulization device (1) further comprises:

- a unit (10) for supplying liquid to the nebulizer (20), said unit being connected to a degradation conduit (12) and being suitable for receiving a nebulization liquid (L);
- a pump (50) coupled to said unit (10) for supplying liquid.

**11.** Nebulization device (1) according to Claim 9 or 10 above, wherein

- the degradation unit (30) is coupled to said degradation conduit (12); and
- said at least one conductivity cell (40) is situated inside the degradation conduit (12).

**12.** Nebulization device (1) according to Claim 10 or 11 above, wherein the nebulization device (1) further comprises a solenoid valve (70) suitable for:

- directing the nebulized nebulization liquid (L) from the unit (10) for supplying liquid to a diffuser (14) if the total organic carbon (TOC) is less than or equal to a predetermined threshold (S); or
- directing the nebulization liquid (L) from the unit (10) for supplying liquid to the degradation conduit (12) if the total organic carbon (TOC) is greater than the predetermined threshold (S); and
- halting the supply of the diffuser (14) with nebulized nebulization liquid (L) if the total organic carbon (TOC) is greater than the predetermined threshold (S).

**13.** Nebulization device (1) according to any one of Claims 9 to 12 above, wherein the degradation unit (30) is disposed inside or outside the degradation conduit (12).

**14.** Nebulization device (1) according to any one of Claims 9 to 13, wherein said unit (10) for supplying liquid is:

- a nebulization reservoir; or
- a nebulization conduit through which the nebulization liquid (L) is able to flow.

_Fig. 1_

Fig. 2

Fig. 3

<u>Fig. 4</u>

<u>Fig. 5</u>

Fig. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2788705